# EUROPÄISCHE PATENTSCHRIFT

(11) **EP 0 363 554 B1**
(45) Veröffentlichungstag und Bekanntmachung des Hinweises auf die Patenterteilung: **13.04.1994**
(21) Anmeldenummer: 89104563.5
(22) Anmeldetag: 15.03.1989
(51) Int. Cl.: H01L 39/24

(54) **Verfahren und Vorrichtung zur Erzeugung epitaktisch und/oder hochtexturiert gewachsener, fremdphasenarmer Filme von Hoch-Tc-Oxidsupraleitern auf Substraten**
Process and apparatus for producing epitaxially and/or highly texturally grown, high TC-oxide superconductor films, lacking in foreign phases, on substrates
Procédé et appareil de fabrication de couches épitaxiales et/ou fortement texturées pauvres en phases étrangères de supraconducteurs d'oxyde à haute température sur des substrats

(30) Priorität: 10.10.1988 DE 3834402
(43) Veröffentlichungstag der Anmeldung: 18.04.1990
(73) Patentinhaber: KERNFORSCHUNGSZENTRUM KARLSRUHE GMBH, D-76021 Karlsruhe (DE)
(72) Erfinder: Schultheiss, Christoph, Dr., D-7500 Karlsruhe (DE); Geerk, Jochen, Dr., D-7513 Stutensee (DE); Karow, Hans, Dr., D-7500 Karlsruhe (DE)

(56) Entgegenhaltungen:
- APPLIED PHYSICS LETTERS, Band 52, Nr. 14, 4. April 1988, Seiten 1193-1195, New York, US; T. VENKATESAN et al.: "Observation of two distinct components during pulsed laser deposition of high Tc superconducting films"
- JAPANESE JOURNAL OF APPLIED PHYSICS, Band 27, Nr. 1, Januar 1988, Seiten L34-L36; S. KOMURO et al.: "Preparation of high-Tc superconducing films by Q-switched YAG lasersputtering"
- APPLIED PHYSICS LETTERS, Band 51, Nr. 21, 23. November 1987, Seiten 1753-1755, New York, US; P.M. MANKIEWICH et al.: "Reproducible technique for fabrication of thin films of high transitiontemperature superconductors"
- JAPANESE JOURNAL OF APPLIED PHYSICS, Band 27, Nr. 8, August 1988, Seiten L1480-L1483, Tokyo, JP; I. TERASAKI et al.: "Superconducting films of YBa2Cu30x and Bi-Sr-Ca-Cu-O fabricated by electron-beam deposition with a single source"
- APPLIED PHYSICS A, Band A48, Nr. 4, April 1989, Seiten 397-400, Berlin, DE; H.P. SCHOLCH et al.: "Production of YBa2Cu307-x superconducting thin films by pulsed pseudospark electron beam evaporation"
- Appl. Phys. Lett. 52 (14), April 1988, Seiten 1185-1186, A. Mogro-Campro und L.G. Turner

## Beschreibung

Die Erfindung betrifft ein Verfahren und eine Vorrichtung zur Erzeugung epitaktisch und/oder hochtexturiert gewachsener, fremdphasenarmer Filme von Hoch-T_{c}-Oxidsupraleitern auf Substraten entsprechend dem Oberbegriff des Anspruches 1.

Ein epitaktisches und/oder hochtexturiertes Wachstum eines supraleitenden Films tritt auf, wenn
(i) die Gitterkonstanten der Substratebene und der supraleitenden Phase des Materials vergleichbar sind,
(ii) die Substrattemperatur der Wachstumstemperatur der supraleitenden Phase entspricht,
(iii) die Aufwachsgeschwindigkeit des Films eine epitaktische Orientierung zuläßt,
(iiii) die Stöchiometrieabweichungen begrenzt sind.

Bemerkenswerte Erfolge bei der Herstellung hochstromtragender Filme von Oxidsupraleitern konnten durch den Einsatz von UV-EXIMER-Lasern erzielt werden. Hierbei löst ein Laserstrahl mit einer genau bemessenen Energiedichte auf dem Spendertarget einen Ablationsproze aus, wodurch dort eine wenige Nanometer dicke Schicht nahezu vollständig verdampft wird.

Im allgemeinen sind die bekannten Oxidsupraleiter-Materialien in der Dampfphase äußerst instabil und zerfallen in ihre Einzelkomponenten. Dennoch beobachtet man bei der Laserablation auf dem Empfängertarget - eine gute bis sehr gute Stöchiometrie. Ein solches Verfahren ist aus einer Vorveröffentlichung von D. Dijkkamp und T. Venkatesan, Bell Communikations Research, Red Bank, New Jersey, bekannt.

Wie aus S. Komuro, Y. Aoyagi, T. Morikawa und S. Namba, Japanese Journal of Applied Physics, Vol. 27, No. 1, January, 1988, pp. L34-L36 hervorgeht, ist beim Auftreffen von Tröpfchen des Supraleitermaterials auf dem Substrat eine Nachglühung bei 900°C notwendig. Bei dieser Temperatur treten bereits sehr heftige Reaktionen zwischen Film und Substrat auf, die deshalb als nachteilig angesehen werden, weil sie eine Vielzahl interessanter Substratmaterialien (ZrO₂ ,Si, Pt, Al₂O₃ etc.) ausschließen. Deshalb wird der Ablationsprozeß so geführt, daß das Supraleitermaterial praktisch vollständig verdampft und der Film auf dem Substrat durch Abscheidung von diskreten Molekülen hergestellt wird.

Die Bildung von Tröpfchen ist besonders häufig zu beobachten, wenn die Energiedichte des Laserstrahls zu hoch bemessen ist oder wenn anstelle der EXIMER-Laser die kostengünstigen langwelligen Laser, z.B. CO₂ oder Argon-Laser, angewendet werden.

Das bekannte Verfahren weist den Nachteil auf, daß wegen der Abscheidung diskreter Moleküle auf dem Substrat der Aufbau eines supraleitenden Films sehr langsam vonstatten geht.

Die Bildung eines 300 nm dicken Films erfodert eine Zeit von etwa einer Stunde.

EXIMER-Laser sind sehr aufwendig und demzufolge teuer. Ihr Wirkungsgrad ist gering. Wegen der Verwendung von Fluorwasserstoff müssen besondere Sicherheitsvorkehrungen getroffen werden. Die erzeugten Filme sind häufig nicht glatt, sondern weisen Erhebungen auf, die nicht zur Stromleitung beitragen können.

Die Verdampfung eines Targets mit einem nicht gepulsten Elektronenstrahl ist aus Jap. J. Appl. Phys., Band 27, Nr. 8, August 1988, Seiten L 1480 - L 1483, Taraski et al. bekannt. Die dabei erzeugten Filme sind zunächt isolierend und werden erst durch eine Temperatur behandlung supraleitend.

Aufgabe der Erfindung ist, die genannten Nachteile zu vermeiden. Insbesondere soll auf den Einsatz eines EXIMER-Lasers verzichtet werden. Der Zeitbedarf zum Aufbau der Supraleiter-Filme soll deutlich vermindert werden und es sollen sich Filme im Bereich bis zu 10 µm herstellen lassen.

Die Filme sollen weitgehend einphasig, d.h. fremdphasenarm sein.

Die Aufgabe wird erfindungsgemäß durch ein Verfahren entsprechend dem Oberbegriff des Anspruches 1 gelöst, das dadurch gekennzeichnet ist, daß das Substrat auf einer Temperatur gehalten wird, bei der die Tröpfchen das Substrat beim Auftreffen benetzen und zu einem gleichförmigen glatten Film erstarren.

Es erweist sich als vorteilhaft, wenn die Substrattemperatur etwa 300-400°C unterhalb der Schmelztemperatur des Hoch-T_{c}-Oxidsupraleiters liegt. Um eine Diffusion von Atomen zwischen Substrat- und Supraleiterschicht zu verhindern, kann es günstig sein, wenn vor der Erzeugung des Supraleiterfilms eine Zwischenschicht, z.B. aus ZrO₂, Al₂O₃ oder SrTiO₃, auf dem Substrat erzeugt wird.

Der Ablationsprozeß wird durch Verwendung eines gepulsten Elektronenstrahls mit einer Energiedichte von etwa 10-20 keV und einer Stromdichte im Bereich von 10³-10⁴ A/cm² eingeleitet und aufrechterhalten.

Die im Ablationsprozeß erzeugten Tröpfchen treffen mit hoher Geschwindigkeit auf das beheizte Substrat, zerfließen dort zu einem dünnen Film, der epitaktisch kristallisiert. Da sich die überwiegende Menge des transferierten Materials in Tröpfchenform befindet, sind die Abweichungen der chemischen Zusammensetzung von der Stöchiometrie sehr gering; sie liegen im allgemeinen unter 1 %. Die erzeugten Filme sind deshalb besonders fremdphasenarm. Bei gepulsten Elektronenstrahlen hängt der Wechselwirkungsmechanismus mit der Materie im wesentlichen von der Massendichte ab. Der Vorteil des Elektronenstrahls ist sein wohldefiniertes Eindringvermögen in das Targetmaterial. Bei einer Elektronenenergie von 10-20 keV liegt die Reichweite in Oxidsupraleitern in der Größenordnung von Mikrometern. Wählt man Stromdichten im Bereich 10³ bis 10⁴ A/cm², dann zerfällt das getroffene Gebiet auf dem Spendertarget explosionsartig in ein Phasengemisch aus flüssigen Tröpfchen und Dampf.

Als Elektronenquelle kann eine Hochleistungsmodifikation der in der DE-PS 28 04 393 beschriebenen Pseudofunkenkammer verwendet werden. Mit ihr wird bei einem elektrischen Wirkungsgrad von etwa 20 % ein selbstfokussierender Elektronenstrahl mit einer Pulslänge von etwa 50 ns hergestellt. Im Vergleich hierzu ist der Wirkungsgrad von EXIMER-Lasern mehr als 20 mal kleiner.

Die Bildung von 300 nm dicken Filmen erfordert dann nur noch Zeiten in der Größenordnung von 5 Minuten.

Es ist zweckmäßig, den Elektronenstrahl in einer isolierenden Hulse zu führen, die mit ihrem einen Ende an der Elektronenquelle angeschlossen ist und mit ihrem freien Ende in die Nähe des Spendertargets reicht. Durch eine solche Hülse wird die Gefahr einer Verschmutzung der Elektronenquelle durch Flüssigkeitströpfchen nahezu ausgeschlossen. Der Abstand zwischen dem freien Ende der Hülse und dem Spendertarget kann wenige Zentimeter bis einige Millimeter betragen.

Der Innendurchmesser der Hülse soll in derselben Größenordnung liegen wie der Durchmesser des Elektronenstrahls. Es ist vorteilhaft, wenn der Innendurchmesser der Hülse etwa zweimal so gro ist wie der Durchmesser des Elektronenstrahls.

Die Führung eines Elektronenstrahls ist selbst in einer gekrümmten Hülse möglich. Die Länge der Hülse kann bis zu einem Meter betragen. Damit eröffnet sich die Möglichkeit, die Elektronenstrahlen vieler parallel angeordneter Pseudofunkenkammern gleichzeitig auf ein Spendertarget zu richten und damit großflächige Filmbeschichtungen auf dem Substrat herzustellen. In diesem Fall wird das Spendertarget vorteilhafterweise als Ring ausgebildet. Das Substrat kann in diesem Fall an dem Spendertarget kontinuierlich vorbeigezogen werden. Es besteht auch die Möglichkeit, ein drahtförmiges Substrat axial durch das Spendertarget zu ziehen.

Um den Verschleiß des Spendertargets zu minimieren und um einen gleichmäßigen Abtrag zu gewährleisten, wird das Spendertarget um seine Achse gedreht.

Die Erfindung wird im folgenden anhand von zwei Ausführungsbeispielen näher erläutert.

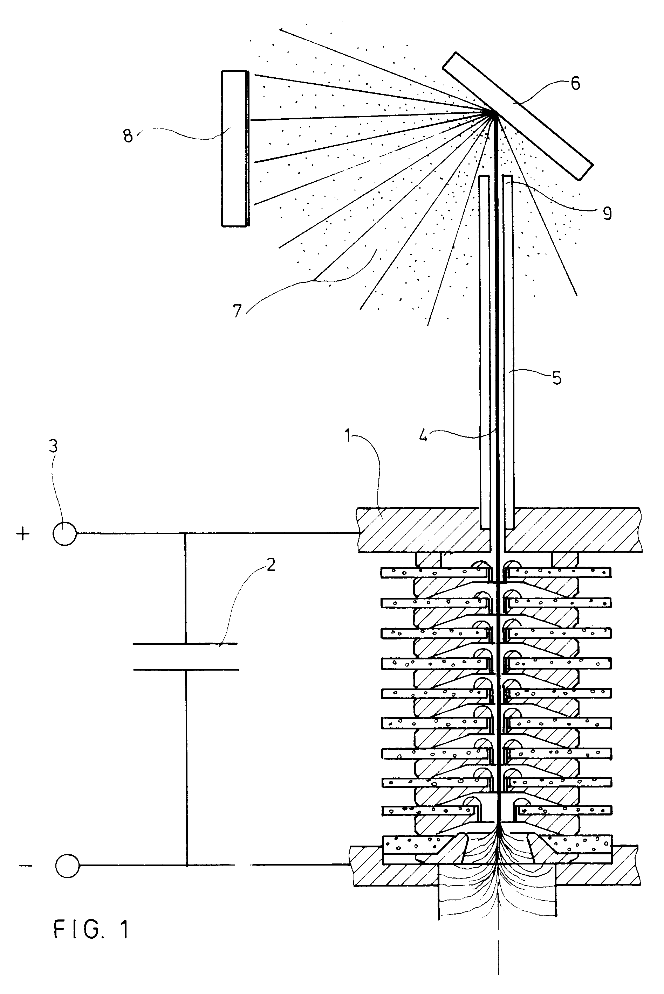

- Figur 1: zeigt eine Anordnung zum Beschichten eines Substrats mit einem Supraleitermaterial.

Als Supraleitermaterial wurde in diesem Fall Y Ba₂ Cu₃ O₇₋ₓ verwendet. Das Substrat bestand aus mit Yttrium stabilisiertem Zirkonoxid (10 % Y); es wurde während der Beschichtung auf einer Temperatur von 820°C gehalten.

Als Betriebsgas wurde Sauerstoff mit einem Partialdruck von 10 Pa verwendet.

Als Elektronenquelle wurde eine Hochleistungsmodifikation einer Pseudofunkenkammer 1 eingesetzt. Die externe Beschaltung besteht aus einer elektrischen Kapazität 2 und einer Hochspannungsversorgung 3. Der Elektronenstrahl 4 mündet in einer Keramikröhre 5 mit einem Durchmesser von 1 bis 2 mm und einer Länge von 10 cm, in der sich der Strahl 4, wegen eines elektrostatischen Fokussiereffektes, nahezu verlustlos zum anderen Ende transportieren läßt. Dort trifft der Strahl 4 auf das Spendertarget 6 und löst durch einen Ablationsprozeß einen Tröpfchennebel 7 aus, der auf dem Empfängertarget 8 aufwächst. Etwaige Sauerstoffverluste an der Oberfläche der Tröpfchen werden durch das Sauerstoff-Betriebsgas teilweise ausgeglichen.

Ein Teil des Tröpfchennebels 7 gelangt auch in das targetseitige Ende der Keramikhülse und legt sicht dort als unerwünschte Verunreinigung 9 nieder. Diese Verunreinigung wird durch den nachfolgenden gepulsten Elektronenstrahl verdampft und größtenteils wieder in Richtung Spendertarget ausgeblasen. Auf diese Weise ist die Standzeit der Pseudofunkenkammer durch die Verschmutzung durch Ablationsdämpfe nicht beeinträchtigt. Bei 5 Joule pro Puls primärer elektrischer Energie konnten ohne eine Änderung der Funktionsweise der Pseudofunkenkammer 400000 Pulse erreicht werden.

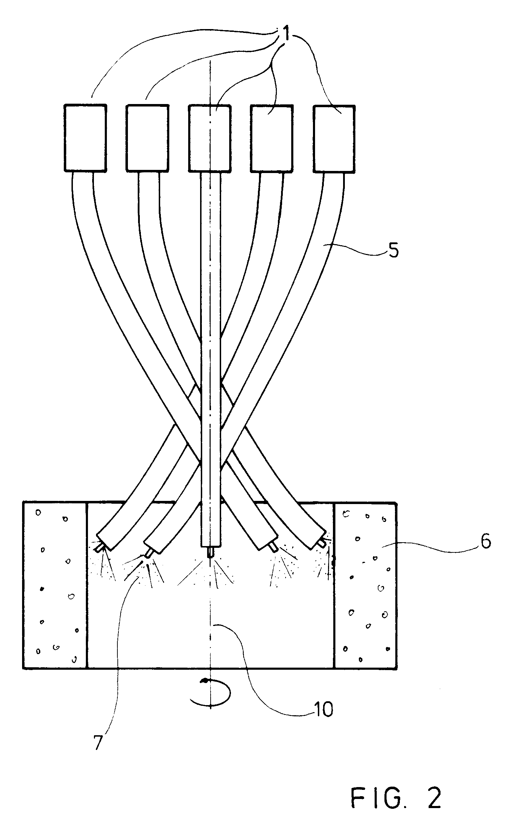

- Figur 2: zeigt eine Anordnung, mit deren Hilfe ein Substrat, z.B. ein Draht, kontinuierlich mit einem supraleitenden Film versehen werden kann.

Als Elektronenquellen 1 werden mehrere Hochleistungsmodifikationen der Pseudofunkenquelle parallel geschaltet. Die Elektronenstrahlen dieser Elektronenquellen 1 werden mit Hilfe von gekrümmten Quarzglas-Hülsen 5 auf ein ringförmiges Spendertarget 6 geführt. Das Spendertarget 6 wird während des Ablationsprozesses um seine Achse 10 gedreht, um einen gleichmäßigen Abtrag zu erreichen. Durch die Ringform des Spendertargets wird der Tröpfchennebel 7, der sich beim Ablationsprozeß bildet, auf einen Raum innerhalb und unterhalb des Spendertargets konzentriert. Durch diesen Raum wird ein Draht in der Rotationsachse 10 kontinuierlich hindurch geführt. Die Zylinderanordnung hat den Vorteil, daß Tröpfchen, die nicht auf das Substrat gelangen, sich zu einem großen Teil wieder auf den Zylinderwänden niederschlagen und für einen weiteren Ablationsprozeß zur Verfügung stehen. Das Spendertarget wird optimal ausgenutzt.

## Patentansprüche

1. Verfahren zur Erzeugung epitaktisch und/oder hochtexturiert gewachsener, fremdphasenarmer Filme von Hoch-T_{c}-Oxidsupraleitern auf Substraten, bei dem mittels gepulster Strahlung auf einem Spendertarget ein Ablationsprozeß eingeleitet und aufrechterhalten wird und dabei entstehende kleine Tröpfchen mit Durchmessern im µ-Bereich auf das geheizte Substrat gelangen,
dadurch gekennzeichnet, daß
als gepulste Strahlung keine Lasestrahlung sondern eine Teilchenstrahlung eingesetzt wird und das Substrat auf einer Temperatur gehalten wird, bei der die Tröpfchen das Substrat beim Auftreffen benetzen und zu einem gleichförmigen, glatten Film erstarren.

2. Verfahren nach Anspruch 1, dadurch gekennzeichnet, daß das Substrat auf einer Temperatur, die 300-400°C unterhalb der Schmelztemperatur des Hoch-T_{c}-Oxidsupraleiters liegt, gehalten wird.

3. Verfahren nach Anspruch 1, dadurch gekennzeichnet, daß vor der Erzeugung des Hoch-T_{c}-Oxidsupraleiter-Films in der selben Weise auf dem Substrat eine oxidationsbeständige Zwischenschicht, vorzugsweise aus ZrO₂, Al₂O₃ oder SrTiO₃, erzeugt wird.

4. Verfahren nach Anspruch 1, dadurch gekennzeichnet, daß als Teilchenstrahlung ein gepulster Elektronenstrahl mit einer Elektronenenergie von etwa 10-20 keV und einer Stromdichte im Bereich von 10³ bis 10⁴ A/cm² eingesetzt wird.

5. Verwendung einer Elektronenquelle, mit der ein gepulster Elektronenstrahl mit einer Elektronenenergie von etwa 10-20 keV und eine Stromdichte im Bereich von 10³ bis 10⁴ A/cm² erzeugt werden kann, zur Ablation von Hoch-T_{c}-Oxidsupraleitermaterial aus einem Spendertarget.

6. Verwendung nach Anspruch 5, wobei der gepulste Elektronenstrahl durch eine aus einem isolierenden Material bestehende Hülse geführt ist, die mit ihrem einen Ende an der Elektronenquelle angeschlossen ist und deren freies Ende in die Nähe des Spendertargets reicht.

7. Verwendung nach Anspruch 6, wobei der Innendurchmesser der Hülse in derselben Größenordnung wie der Durchmesser des Elektronenstrahls liegt.

8. Verwendung nach den Ansprüchen 6 oder 7 mit mehreren parallel angeordneten Elektronenquellen, deren angeschlossene Hülsen einen gekrümmten Verlauf aufweisen und mit ihren freien Enden auf ein ringförmiges, um seine Achse drehbares Spendertarget weisen.

9. Verwendung nach Anspruch 8 mit einem ringförmigen Spendertarget, an dem ein drahtförmiges Substrat vorbei- oder durchführbar ist.

## Claims

1. Method of producing epitactically and/or highly texturally grown, high T_{c} oxide superconductor films, which are low in foreign phases, on substrates, wherein an ablation process is introduced and maintained by means of pulsed radiation on a donor target, and small droplets, produced thereby and having diameters in the µ range, impinge upon the heated substrate, characterised in that no laser radiation, but a particle radiation, is used as the pulsed radiation, and the substrate is kept at a temperature where the droplets wet the substrate upon encountering such and harden to form a uniform, smooth film.

2. Method according to claim 1, characterised in that the substrate is kept at a temperature which lies 300-400° C below the melting temperature of the high T_{c} oxide superconductor.

3. Method according to claim 1, characterised in that an oxidation-resistant intermediate layer, preferably formed from ZrO₂, Al₂O₃ or SrTiO₃, is produced on the substrate in the same manner prior to the production of the high T_{c} oxide superconductor film.

4. Method according to claim 1, characterised in that a pulsed electron beam, having an electron energy of about 10-20 keV and a current density in the range of between 10³ and 10⁴ A/cm², is used as the particle radiation.

5. Use of a source of electrons, whereby a pulsed electron beam, having an electron energy of about 10-20 keV and a current density in the range of between 10³ and 10⁴ A/cm², may be produced for the ablation of high T_{c} oxide superconductor material from a donor target.

6. Use according to claim 5, wherein the pulsed electron beam is guided through a sleeve, which is formed from an insulating material and communicates, by its one end, with the source of electrons, its free end extending into the vicinity of the donor target.

7. Use according to claim 6, wherein the internal diameter of the sleeve is of the same order of magnitude as the diameter of the electron beam.

8. Use according to claim 6 or 7 with a plurality of sources of electrons, which are disposed parallel to one another, and the communicating sleeves of which have a curved configuration and point, with their free ends, to an annular donor target which is rotatable about its axis.

9. Use according to claim 8 with an annular donor target, a wire-like substrate being guidable past or through said target.

## Revendications

1. Procédé de fabrication de couches épitaxiales et/ou fortement texturées, pauvres en phases étrangères de supra-conducteurs d'oxyde à haute température sur des substrats, dans lequel au moyen d'un rayonnement pulsé sur une cible dispensatrice un processus d'ablation est déclenché et est maintenu vertical, en outre de fines gouttelettes prenant naissance arrivent sur le substrat chauffé avec des diamètres au niveau de micron caractérisé en ce que comme rayonnement pulsé on utilise non pas un rayonnement laser mais par contre un rayonnement de particules et le substrat est maintenu à une température, à laquelle les gouttelettes mouillent le substrat lors de leur contact avec lui et se solidifient en une couche lisse, homogène.

2. Procédé selon la revendication 1, caractérisé en ce que le substrat est maintenu à une température, qui se situe à 300-400°C en-dessous de la température de fusion du supra-conducteur d'oxyde à haute température.

3. Procédé selon la revendication 1, caractérisé en ce qu'avant la production de la couche du supra-conducteur d'oxyde à haute température on crée de la même manière sur le substrat une couche intermédiaire résistant à l'oxydation, composée de préférence de ZrO₂, Al₂O₃ ou SrTiO₃.

4. Procédé selon la revendication 1, caractérisé en ce qu on met en oeuvre comme rayonnement de particules un faisceau d'électrons ayant une énergie électronique d'environ 10-20 keV et une densité de courant dans la gamme de 10³ à 10⁴ A/cm².

5. Utilisation d'une source d'électrons, avec laquelle on peut créer un faisceau d'électrons pulsé ayant une énergie électronique d'environ 10-20 keV et une densité de courant dans la gamme de 10³ à 10⁴ A/cm², pour l'ablation de matériau de supraconducteur d'oxyde à haute température à partir d'une cible dispensatrice.

6. Utilisation suivant la revendication 5, dans laquelle le faisceau d'électrons pulsé est guidé par une gaine composée d'un matériau isolant, qui est raccordée par une de ses extrémités à la source d'électrons et dont l'autre extrémité arrive au voisinage de la cible dispensatrice.

7. Utilisation selon la revendication 6, dans laquelle le diamètre intérieur de la gaine est du même ordre de grandeur que le diamètre du faisceau d'électrons.

8. Utilisation selon les revendications 6 ou 7, avec plusieurs sources d'électrons disposées en parallèle, dont les gaines jointes ont une allure courbe et indiquent avec leurs extrémités libres une cible dispensatrice annulaire, pouvant tourner autour de son axe.

9. Utilisation selon la revendication 8, avec une cible dispensatrice annulaire, dans laquelle on peut faire passer ou réaliser un substrat en forme de fil.
